# EUROPEAN PATENT APPLICATION

(11) **EP 4 498 162 A1**
(43) Date of publication of application: **29.01.2025**
(21) Application number: 23188093.1
(22) Date of filing: 27.07.2023
(51) Int. Cl.: G03F 7/20

(54) **MACHINE CONSTANT OPTIMIZATION METHOD AND ASSOCIATED APPARATUSES**

(71) Applicant: ASML Netherlands B.V., 5500 AH Veldhoven (NL)
(72) Inventor: LIANG, Lei, 5500AH Veldhoven (NL); HERMANS, Tom, Johannes, Joseph, 5500 AH Veldhoven (NL); SHAN, Juan, 5500AH EINDHOVEN (NL); PASVEER, Willem, Franke, 5500AH Veldhoven (NL)
(74) Representative: ASML Netherlands B.V.

(57) **Abstract**

The disclosure provides a method of determining a set of machine constants used for a model of interest related to at least one parameter of interest and to a process; the method comprising: obtaining process data relating to said process; obtaining a set of optimization ranges, comprising a respective optimization range calibrated for each machine constant of said set of machine constants; and optimizing said set of machine constants within said set of optimization ranges based on said process data.

## Description

### FIELD

The present invention relates to methods and apparatus usable, for example, in the manufacture of devices by lithographic techniques, and to methods of manufacturing devices using lithographic techniques. The invention relates more particularly to metrology sensors and calibration of such metrology sensors.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Performance of EUV scanners suffers from carbon contamination. Contamination may cause drift in output or performance for, for instance, sensor and fiducial.

Carbon contamination is mostly caused by the carbonization of the photoresist volatile under exposure of EUV radiation. Currently, cleaning by hydrogen radical generation (HRG) is the way to remove the contamination. However, frequent cleaning and sensor matching (involving sensor and fiducial) are required. Both cost time as the lithographic apparatus and process need to be stopped. In a business where availability and machine uptime are very important for margins, reduced availability is a significant disadvantage.

### SUMMARY

The present disclosure provides a method of determining a set of machine constants used for a model of interest related to at least one parameter of interest and to a process; the method comprising: obtaining process data relating to said process; obtaining a set of optimization ranges, comprising a respective optimization range calibrated for each machine constant of said set of machine constants; and optimizing said set of machine constants within said set of optimization ranges based on said process data.

Other aspects provide a computer program, computer program carrier, processing arrangement, lithography apparatus and metrology apparatus arranged to perform said method.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2 shows a cross-sectional side view of a substrate and a sensor of the lithographic system;
- Figure 3 shows a cross-sectional side view of an area within the lithographic apparatus during use thereof, schematically indicating potential deposition of contaminants;
- Figure 4 shows a diagram indicating exemplary steps of a prediction method;
- Figure 5 shows a diagram indicating inputs and outputs of a prediction method;
- Figure 6 shows a diagram of a conversion factor CF against sensor usage SU, adjusted using a prediction method;
- Figure 7 is a flowchart describing a machine constant optimization method according to an embodiment;
- Figure 8(a) is a flowchart describing a data classifier training method according to an embodiment;
- Figure 8(b) is a flowchart describing an optimization range determination method according to an embodiment;
- Figure 9 depicts four different drift profiles of a calibration metric, illustrating four example data classes relating to a data classifier of an embodiment;
- Figure 10 depicts example constrained optimization ranges, determined according to an embodiment;
- Figure 11 is a flowchart describing an optimization method according to an embodiment; and
- Figure 12 is a flowchart describing an optimization method according to an embodiment.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. These terms may be used interchangeable and synonymously.

The term "pellicle" may refer to a protective layer typically positioned in front of the reticle. For detail see, for instance, US patent number US 10983431, incorporated herein by reference.

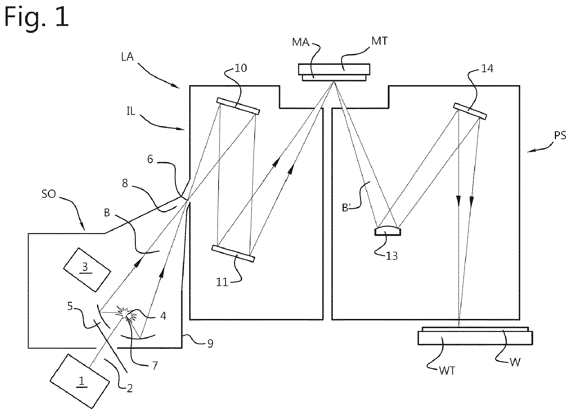

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, which may, for example, include a COz laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source or a free electron laser (FEL) may be used to generate EUV radiation.

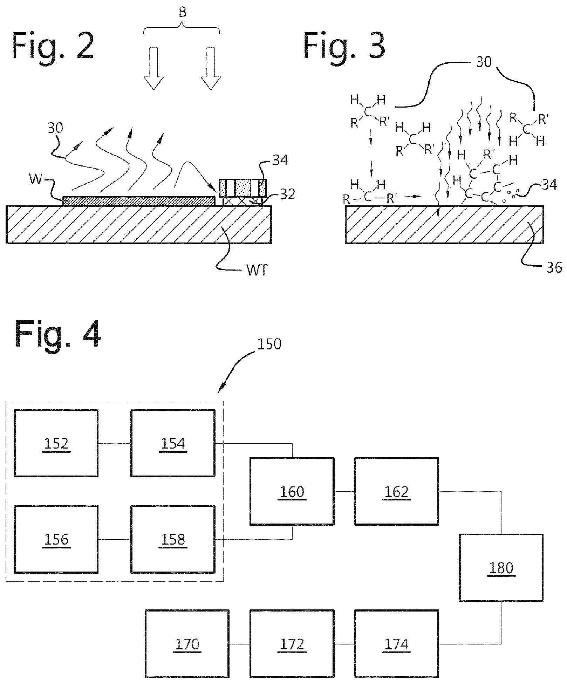

Generally referring to Figures 2 and 3, performance of an EUV scanner suffers from contamination, most notably carbon contamination. Contamination may cause drift in the output of, for example, a sensor and fiducial. Examples of contamination are plasma induced carbonization, EUV induced carbonization, airborne contamination, absorbed organic molecules from photoresists, and anything that can block EUV from reaching to the sensor.

Carbon contamination is mostly caused by the carbonization of the photoresist volatile under EUV exposure. A photoresist (also known simply as a resist) is a light-sensitive material used in several processes, such as photolithography, to form a patterned coating on a surface. The process begins by coating a substrate with a light-sensitive material, typically an organic material. As described with reference to Figure 1, a patterned mask MA is then applied to the surface to block light, so that only unmasked regions of the material will be exposed to radiation. A solvent, called a developer, is then applied to the surface. In the case of a positive photoresist, the photo-sensitive material is degraded by light and the developer will dissolve away the regions that were exposed to light, leaving behind a coating where the mask was placed. In the case of a negative photoresist, the photosensitive material is strengthened (either polymerized or cross-linked) by radiation, and the developer will dissolve away only the regions that were not exposed to light, leaving behind a coating in areas where the mask was not placed.

Examples of photoresist include, but are not limited to, methyl methacrylate monomers, Polymethyl methacrylate (PMMA), acrylate monomer, a mixture of diazonaphthoquinone (DNQ) and novolac resin (a phenol formaldehyde resin) commonly referred to as DNQ-Novolac photoresist, and epoxy-based polymer.

Referring to Figure 2, the wafer W is provided with a layer of photoresist. Upon exposure with a beam B of radiation, exposed sections of the resist may turn into volatile components 30. As indicated in Figure 3, the components 30 may typically include a reactive part, i.e. the volatile components may be regarded as free radicals. The latter can deposit on any surface within the lithographic apparatus LA. The volatile components 30 may, for instance, deposit on a sensor 32. The components 30 may deposit on the sensor 32 or any surface 36 (Fig. 3), forming a patch or layer of deposit 34.

The sensor 32 is typically located near the wafer W to measure and calibrate the energy of radiation in the beam B. Due to its location relatively near the wafer, the sensor 32 is especially vulnerable to deposition of volatile components 30. However, the volatile components 30 may deposit on other surfaces 36 as well, including surfaces of mirrors 5, 10, 11, 13, 14, the mask MA and associated parts such as the reticle, or any part of the walls of the projection system PS and illumination system IL.

During a lithographic process using the lithographic apparatus LA, carbon containing contaminants may build up on internal surfaces of the lithographic apparatus, as described with respect to Figures 2 and 3. The reading (output) of the sensor 32 may drift, i.e. diverge, as a result of the contamination. Thus, drift of the output of the wafer stage sensor 32 may be a result of contamination. Scanner sensor calibration costs time, and therefore negatively influences the availability (uptime) of the lithographic apparatus.

During the lithographic process, a so-called sensor conversion factor (CF) can be used to translate light intensity as measured by the sensor 32 (with an output typically in a digital form, i.e. in bits) to a required dose of radiation (mJ/cm²). Conventionally, the conversion factor is determined using an event referred to as sensor matching. Sensor matching requires the lithographic apparatus LA to shut down temporarily, to allow matching or calibrating the output of the sensor 32 to the dose of radiation provided. As a result, sensor matching decreases the availability or uptime of the lithographic machine LA. Minimizing the times of calibration therefore increases uptime and revenue.

The sensor 32 may comprise a slit and may be located at or near the wafer W. The sensor 32 may be frequently exposed to EUV radiation. Sensor contamination is mostly caused by the volatiles of the photoresist originating from exposure to EUV radiation. In order to make sure the conversion factor is within specified tolerances (for example <0.5%), conventionally, operators of the apparatus LA may perform more frequent sensor matching, to ensure that the conversion factor used has not drifted from the real value more than the required maximum. Typically, with more contaminant on the sensor, the reading of the sensor 32 will be larger.

The sensor can be cleaned by hydrogen radical generation (HRG). However, this action decreases the availability of the lithographic apparatus LA.

Proposed is a feedforward method to predict the conversion factor CF at any time when requested with less frequent sensor matching input.

Figure 4 shows an exemplary flow chart of a potential cause of a jump in the conversion factor CF of the sensor 32. Figure 4 schematically indicates steps in a lithographic process. Herein, subset 150 of steps has characteristics of, or resembles, a chemical vapor deposition process.

The lithographic process includes a step of wafer cycling 152, i.e. exposing subsequent wafers to radiation in a lithographic process. The latter results in volatile organic compounds in the lithographic apparatus, indicated by step 154. The process 150 also includes a sensor matching step 156. During the process 150 however, the volatiles deposit on the inner surfaces of the apparatus LA, indicated by step 158.

A result of the deposition step 158 is a drift of the sensor reading, resulting in, typically, a drift rate or slope of the drift. The latter is indicated by step 160. In step 162, an estimation method may be used to estimate the sensor output. The estimation step 162 may use, for instance, linear regression.

A cleaning step 170 may involve hydrogen radical generation. After cleaning in step 170, the deposited contamination may have been substantially entirely removed, resulting in a step change or jump in the output of the sensor. The latter is indicated in step 172, indicating a jump in sensor output. Following step 172 is a step of jump correction 174, i.e. a significant correction of the sensor reading incorporating the jump in output 172.

The result of the combination of cleaning 170 and relatively slow drift in output 160 is combined in a prediction step 180. The step 180 may be referred to as a feed forward prediction model.

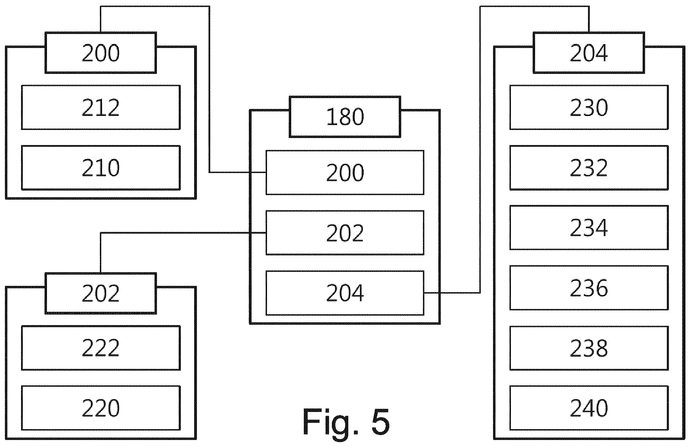

Referring to Figure 5, the feedforward prediction model 180 may comprise an input 200, output 202, and an algorithm 204. The input 200 may comprise the conversion factor 210, and sensor usage count 212. The output may include an event log 220 and a scanner performance monitoring and analysis database 222. The algorithm may take into account information or input relating to training 230, (optional) detection of hydrogen radical generation 232, memory update 234, fitting 236, prediction 238, and/or verification 240.

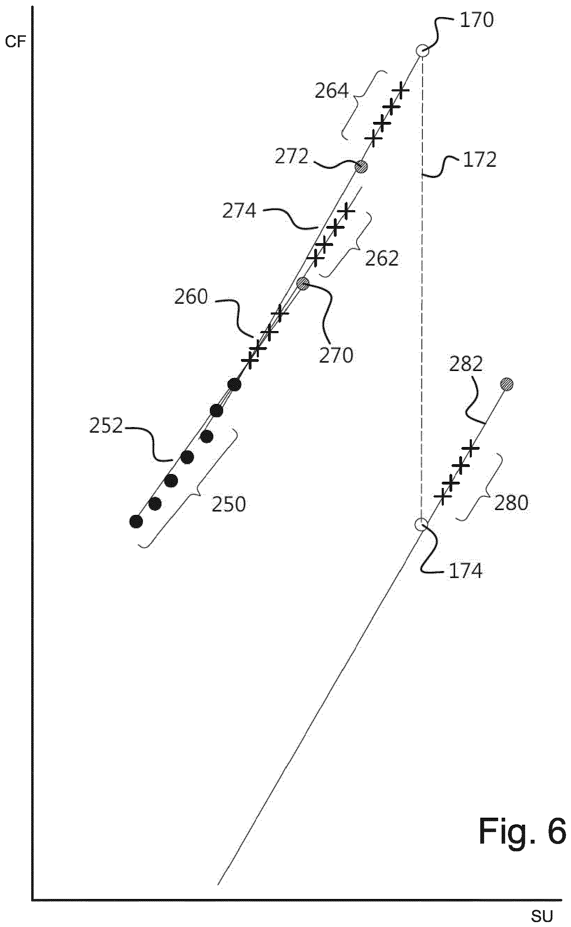

Generally referring to Figure 6, at a high level the algorithm 204 works as follows:
- First collect a few inputs 250 as a training phase to make a linear fitting and obtain fit parameters (slope 252 and offset).
- Whenever the conversion factor CF is needed, such as for uniformity refreshment or for calibration, performance and/or diagnostics tests, the system makes a prediction 260, 262, 264 by taking into account the fit parameters and the predictor used. Inputs may include counter type inputs, such as an output of a slit energy counter.
- When there is a sensor matching event 270, 272 (which may still be done, but at a significantly reduced frequency compared to the conventional setup), the memory is actively updated to store data for fitting. A new fitting is made to change the fit parameters. The latter results in an adjusted slope 274 of the linear regression.
- When during the sensor matching there is a jump in measured conversion factor CF, this offset is corrected by removing the difference between the predicted conversion factor CF and the measured conversion factor CF.

At some point the sensor reading may exceed a predetermined threshold, prompting a cleaning step 170. The resulting jump or drop 172 in sensor reading results in an adjusted sensor reading 174. The adjusted sensor reading 174 may involve a sensor matching event.

The process continues based on the adjusted reading 174 with predicted sensor output values 280 based on slope 282 of a prediction model, such as linear regression.

Use of the feedforward algorithm is exemplified herein below. Before every substrate exposure, the scanner sensor will be used to measure the radiation dose. The usage of the scanner sensor will cause a constant, which may be referred to as "the cumulated number of sensor usage count (NC)", to be increased by 1.

During the maintenance time of the lithographic apparatus, sensor matching is typically performed. The result of sensor matching is the sensor conversion factor (CF). Simultaneously, the current NC will be saved to a feedforward function memory, together with the conversion factor CF, as (xᵢ, yᵢ).

The feedforward model may distinguish between three periods: a training period, a prediction period, and a verification period.

During the training period, the system aims to collect an input of array X = [x₁, x₂, ..., xₙ] and array Y = [y₁, y₂, ..., yₙ]. Also, during training the algorithm aims to get initial fit parameters (m, q) via linear fitting of Y = m*X + q. Herein, X comprises an input of NSUC and Y composes an input of the CF. NSUC may be the number of sensor usage count.

At the end of the training period, when initial fit parameters have been obtained, a length of input array X and Y may be reduced to a threshold number, for instance according to a machine constant determined to memory size or buffer size.

A downsize process may use the full range of X and Y and selected data X', Y', after downsizing in memory will be evenly sampled within X and Y.

During the prediction period, the system may apply the fit parameters (m, q) to input a and make a prediction of b according to b = m*a + q. The predicted value b will be used in the lithographic process.

The fit parameters (m, q) will be updated upon receiving a new sensor matching result (xᵢ, yᵢ). Linear fitting is performed based on the array of [X', Y'] after removing the oldest data (xᵢ, yᵢ) and appending the newest data (xᵢ, yᵢ).

During the verification period, the system may check the quality of the feedforward model without applying the predicted result to the lithographic process. All steps are the same as the prediction period, except that the predicted value b = m*a + q will not be used in the lithographic process.

The frequency of new sensor matching events may be controlled by two machine constants. Said constants may be referred to as a first sensor validity time, used in the training period, and a second sensor validity time used in the prediction period. The first validity time may also be used during the verification period. Whenever the time interval between two sensor matching events exceeds one or both of the aforementioned machine constants, the sensor reading is regarded as invalid and the exposure sequence will be aborted until a new sensor matching event is executed.

The quality of the fitting process may be determined by a key performance indicator or prediction accuracy metric such as prediction inaccuracy (PI). The prediction inaccuracy PI may be determined whenever the result of a new sensor matching event (xᵢ, yᵢ) is saved to the feedforward memory. The PI may be calculated based on (yᵢ - m^{∗}xᵢ - q)/yᵢ^{∗}100%.

A cleaning action of the scanner sensor and the contamination sensor results in a significant change of the CF. This results in a relatively large PI. At the end of a sensor cleaning action, the sensor reading is regarded as invalidated. A new sensor matching event will add the CF after cleaning (xᵢ, yᵢ) to the feedforward memory.

When the prediction inaccuracy PI exceeds a pre-defined first threshold, which may be referred to as the large CF jump threshold, the value of the CF in the feedforward memory will be updated before performing the fitting.

The correction of the CF is done by subtracting the offset determined as (yᵢ - m*a - q), wherein a is the NC from the sensor matching after cleaning, from the CF in memory. After removal of the CF offset, the fit parameters can be updated once again by fitting Y" = Y' - (yᵢ - m*a - q) to X'.

When the prediction inaccuracy PI exceeds a pre-defined second threshold, referred to as the "small CF jump threshold', the feedforward memory size will be shortened to allow a faster response to the latest input.

To model one or more aspects of a lithographic machine or metrology machine, e.g., to determine a predicted value for a parameter of interest from multiple input parameters, multiple machine constants (e.g., constants relating to a process performed on the machine and which are related to the predicted value) may be chosen for e.g., best performance and/or prediction accuracy (or other KPI). Such predictions may be used because the sensor readings become unreliable due to degradation and/or contamination. Regular maintenance actions may be performed, but these tend to result in machine downtime and lost productivity, which is undesirable. Therefore, an optimization of a model of interest such as a prediction model may be performed. The model of interest, for example, may be able to predict a calibration metric, e.g. a conversion factor as has been described, such that the predicted calibration metric may be used to predict a sensor output value. Performance of the model of interest depends on the values attributed to the machine constants which at least partially define the model of interest.

Optimizing a single set of machine constants for a population of machines is suboptimal as there may be significant machine-to-machine variation. Because of this, the machine constants are typically not fixed but instead can be tuned or adjusted within a range of values such that a per-machine optimization can be performed as and when required. The overall performance (e.g., prediction accuracy) of the modeled functionality (e.g., determining a conversion factor for sensor value prediction) depends on the machine constant values.

A method is proposed herein which determines (e.g., optimizes) the machine constants for such a model of interest. The main description will describe the proposed methods and concepts in terms of a feed forward prediction model such as the feed forward prediction model described in relation to Figures 4 to 6 above, for predicting a conversion factor for a sensor such as a dose sensor. However, the concepts are not so limited and can be used for optimizing or determining machine constants for any model for which overall performance of the model depends on the setting of such machine constants.

In the particular specific application provided, the machine constants may include those already mentioned; for example *inter alia:* first and second sensor validity times, small and large CF jump thresholds and/or other machine constants such as a minimum sensor usage count increment threshold or other training machine constants (number of training points, minimum number of lots for training, number of points on which the linear regression model is based). These are purely exemplary and the number of machine constants and what they represent may differ from any specific examples given (of course, if the model differs from the example described, then the machine constants will be different). The specific example described below will describe a co-optimization of eight machine constants relevant to the model described in relation to Figures 4 and 6. The number of machine constants to be optimized, for example, may be more than 2, more than 3, more than 4, more than 5, more than 6 or more than 7.

The proposed method aims to provide an optimal set of machine constants for a given machine at a particular time. For example, the machine constants may be updated (re-optimized) every time an exposure recipe is updated. Because of the computational time constraint when calibrating inline (or during downtime), it is desirable that the proposed optimization method is able to provide the optimized set of machine constants in the shortest possible time, e.g., on the order of minutes rather than hours. Because of this, varying all machine constant combinations over the entire solution space is too slow and therefore not feasible. In an embodiment, the proposed methods may be performable in such timescales (e.g., on the order of minutes) and therefore may be particularly useful when speed of optimization is important.

The proposed method may comprise three main blocks, a data generator for generating training data, a data classifier for classifying the data into two or more classes depending on one or more characteristics of the training data (and production data after training and in use) and a machine constant optimizer for optimizing the set of machine constants separately per class. The characteristics of the training data may relate to the training data as modeled according to the model of interest (e.g., feed forward prediction model).

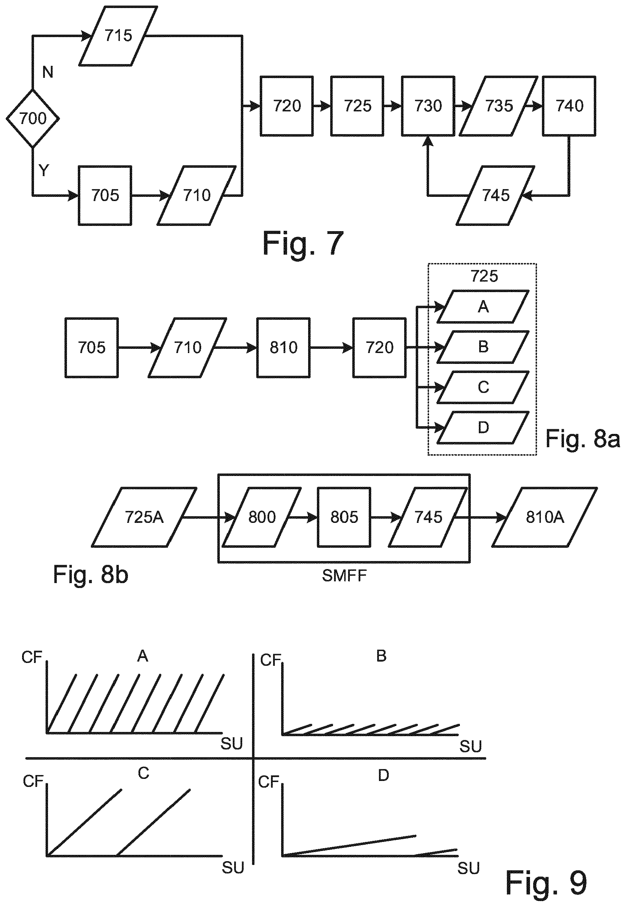

Figure 7 is a flow diagram overview of the proposed method according to an embodiment. At 700 it is determined whether a training mode is to be run, to train or update the model (e.g., to train/update the data classifier 720 and machine constant optimizer 730). If yes Y, than the data generator 705 is used to generate training data 710.

The data generator may generate training data which simulates machine data or process data which mimics real machine/process data. As such, using the specific example otherwise described, the data generator may simulate sensor drift behavior (e.g., in terms of the sensor conversion factor with respect to sensor usage). Such a simulation may comprise simulating a large area of the possible machine behavior space, e.g., to simulate all possible machine behaviors, based on a number of simulation parameters on which the machine behavior is dependent. As such, the simulation may simulate all possible combination of values for all of these simulation parameters. In the specific example describe here, the simulation parameters may comprise *inter* alia, one or more of: baseline value for the conversion function, a drift rate for the conversion function, any conversion function validity time parameter, conversion function measurement accuracy metric or repeatability metric, exposure time parameter, parameters relating to one or more cleaning actions (e.g., describing the effect of and/or frequency and/or number of maintenance actions or cleaning actions). In this manner, the machine learning model can be fed with a very large amount of labeled data (i.e., being simulated, or relevant simulation parameter values are known). Of course, these simulation factor will be dependent on the process being simulated (which in turn is dependent on the model for which the machine constants are being calibrated for) and therefore may differ from the explicit examples recited here.

At step 720 the data classifier is trained. This training sequence for training or updating the data classifier is described by the flowchart of Figure 8(a). Training data 710 is simulated 705 (as has been described) and used to train 810 a data classifier model 720, which may be any suitable machine learning classifier (e.g., a neural network based model or other suitable architecture). The training may employ supervised training techniques, with the simulated data being labeled by the known (i.e., as set) simulation parameter values. The data classification model is trained to classify the training data into classified data 725 comprising two or more classes or classifications based on e.g., characteristics and/or trends of the training data (e.g., a sensor drift profile or calibration metric drift profile over time and/or sensor usage). As is known, the training may be followed by a verification step using known verification principles.

In Figure 8(a), the classifier is trained to classify data into four classes A, B, C, D, although this is only an example. In the example sensor model embodiment given, the four classes may relate to one or more drift characteristics or sensor drift trends in the training data. More specifically these trends may be classified according to two dimensions described by the sensor drift trend: frequency of maintenance actions such as cleaning actions (which manifests as a jump in the modeled value in the sensor drift) in one dimension and the rate of drift of a parameter of interest (e.g., the parameter modeled by the model of interest) in another dimension.

While it has been demonstrated that such a data classifier can correctly classify machine data with good accuracy (e.g., on the order of 90% or better accuracy), the accuracy performance of the classifier is not crucial. An incorrect classification will not mean that the machine constant optimizing process will be incorrect. The classification step only simplifies the problem and speeds up the final step.

Figure 9 comprises plots of the conversion factor CF against sensor usage SU illustrating the four classes in an example. Class A describes data which may be classified as high slope (fast drift) and high frequency cleaning (which resets the drift state such that the slope restarts from the baseline). Class B describes data classified as low slope (slow drift) and high frequency cleaning. Class C describes data classified as high slope and low frequency cleaning and Class D describes data classified as low slope and low frequency cleaning. Note that, for each dimension, whether something is low or high frequency or drift may be determined with reference to a respective threshold (i.e., below a threshold is low and above the threshold is high). These are purely exemplary classes which have been demonstrated to be effective in the specific example provided. It can be appreciated that the one or more of the dimensions may relate to a different trend than drift rate and/or cleaning frequency, one or more additional dimensions may be included, and/or the choice for one or more dimensions may be non-binary (e.g., low, intermediate and high or a greater granularity).

Returning to Figure 7 in a training mode, the machine constant optimizer 730 may be trained on the classified training data 725 to reduce the optimization range (i.e., the search space) per class and per machine constant. This training is illustrated in Figure 8(b). The classified data of a single class 725A is used with a set of machine constants 800 (e.g., an initial set or pre-trained set) with a model of interest 805 (e.g., the feedforward model) and a resultant KPI 745 (e.g., an accuracy metric such as prediction (in)accuracy) assessed. In doing this for the various simulated data, the reduced optimization ranges can be determined. For example, per class, the sensitivity of the KPI 745 to each machine constant can be assessed and those machine constants deemed to have lower sensitivity may have their optimization ranges reduced (e.g., around an initial value and/or previously determined machine constant value). By contrast, a principal component machine constant may be identified, this being the machine constant with highest sensitivity. As such, each optimization range may be scaled in accordance with the sensitivity of its respective machine constant. The sensitivity may be determined by considering the standard deviation (or other suitable statistical measure) of the KPI 745 for each machine constant, where a high standard deviation indicates low sensitivity. Reducing the optimization range for each machine constant per class in this manner saves optimization time when optimizing or updating the machine constants. The result of the flow of Figure 8(b) is a set of optimization ranges 810A for the class in question. This flow can then be repeated for all other classes of the classified data.

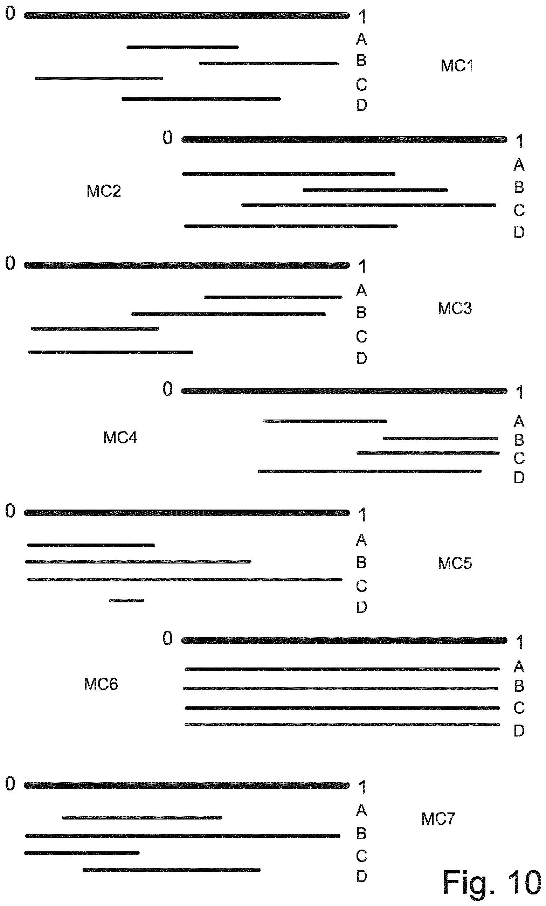

Figure 10 conceptually illustrates the result of the optimization range reduction step. The Figure represents the determined optimization range per category A, B, C, D, by the length and position of a respective line for each of the categories with respect to a (normalized) full range represented by thicker line 0 to 1. This is shown for each of the machine constants MC1-MC7. This can be seen to result in a significantly reduced solution space overall.

Returning to Figure 7, once training is completed the flow may operate in a production mode (i.e., training mode 700 is no N). Process data or machine data 715 obtained during an exposure process (or metrology process or other process) is collected. The trained data classifier 720 classifies the process data 715 to obtain classified data 725 (e.g., the machine data may be classified into one of classes A-D in the specific example shown). This class then defines the solution space within which the optimization will be constrained. By way of a specific example, should the classified data 725 have been classified to class B, then the optimization ranges (solution space) will be those represented by the line B for each machine constant in Figure 10.

A machine constant optimizing step 730 optimizes the machine constants by searching for a solution within the constrained optimization ranges defined as described in relation to Figure 8(b) for the data class identified at step 725. This may be achieved iteratively by determining a candidate set of machine constants 735 within the constrained solution space (for the determined class). This candidate set of machine constants can then be assessed by using the set in a (e.g., feedforward) model 740 as described (e.g., a sensor matching feedforward model for determining a calibration metric) and assessing the model result (e.g., a predicted value), for example against or in terms of a KPI 745. For example the KPI may comprise an accuracy metric relating to the prediction accuracy. This method may be repeated iteratively for different candidate solutions (e.g., such that the solution improves every iteration until convergence on an optimized set).

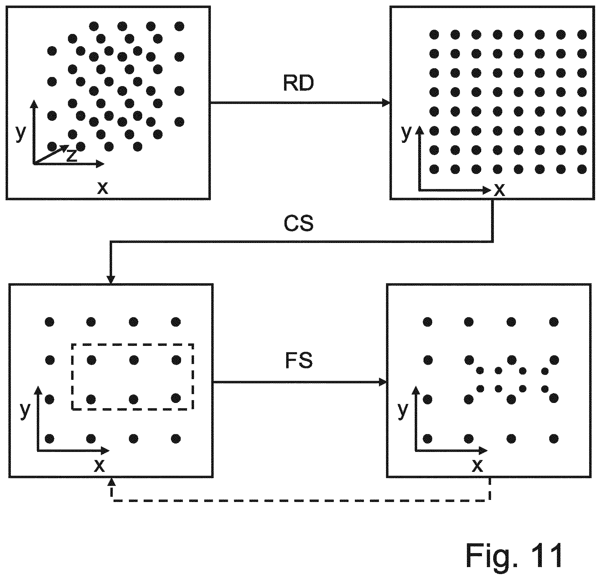

This machine constant optimization may be performed in a number of steps as described by the flowchart of Figure 11 in an embodiment. An initial step RD may be performed to reduce the dimensionality levels e.g., to remove less dominating parameters. This may ne based on the principal component and/or sensitivity analysis result e.g., as obtained in performing the method of Figure 7. A coarse search CS can then be performed in the constrained optimization space to find a local optimum of the best performance. The coarse search CS may start from the default set of machine constants or the set of machine constants after a previous optimization process. The output of the coarse search CS is a further constrained solution space. This can be followed by the iterative fine search FS of the further reduced search range of the further constrained solution space.

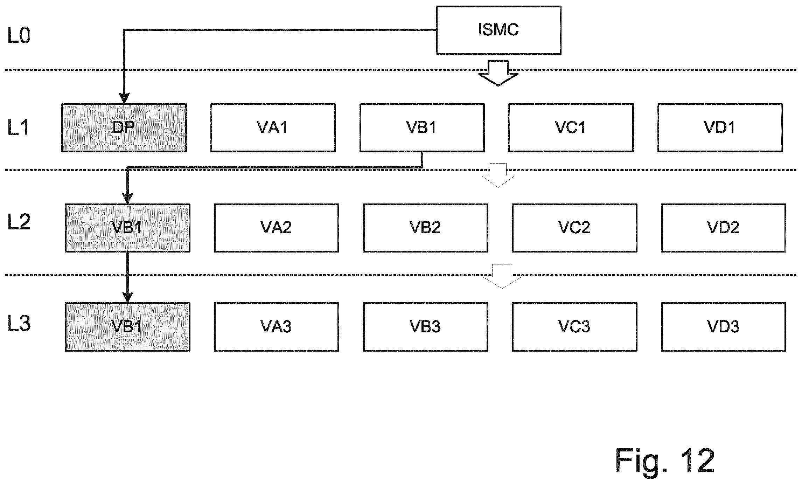

Figure 12 illustrates a machine constant optimization method in an embodiment. Such an optimization method may comprise the fine search FS of Figure 11, and is configured for preventing becoming stuck at a local optimum which is not the global optimum. An initial set of machine constants ISMC (first candidate set of machine constants) is chosen. For example, this initial set of machine constants may be chosen to be at the center within the constrained solution space or within the further constrained solution after the coarse search CS step. In a first optimization step or optimization layer L1, one or more variations VA1, VB1, VC1, VD1 of the default parameters may be determined and assessed. For example, in each variation, a random small change of the machine constant value may be imposed for one or more of the machine constants. The assessment of these variations may determine if any variation improves the performance (e.g., according to a KPI such as prediction accuracy). If so, the algorithm creates a new layer L2 to further search for the optimum machine constant combination via a new set of variation VA2, VB2, VC2, VD2. This is repeated for the next layer L3 provided again that one of variation VA2, VB2, VC2, VD2 improves performance, so as to determine variations VA3, VB3, VC3, VD3. However if none of the variations at each layer improve performance, the best performing variation from the previous layer may be propagated to the next layer (gray boxes) to prevent falling in a local optimum. At each layer, each variation is random, but only those which improve performance are propagated to the next level.

One or more dominating machine constants in respect of the KPI (e.g., prediction performance) can be determined by repeating the algorithm described in relation to Figure 12, so as to assess the distribution (standard deviation) of each machine constant, as output after all iterations. The larger this variation, the less dominant the machine constant is. This can be determined in the aforementioned training phase. The optimizer can be configured to limit variations such that only the one or more dominating machine constants are varied, at least for some layers (e.g., one or more of the earliest layers). As such, the variations of at least some steps may be limited to one or more machine constants which are determined to be most sensitive.

The machine constant optimization may be performed per machine for a population of machines and/or at different time periods on a single machine/each machine of the population.

If the machine constant optimization algorithm uses process data, the process data may cover a certain time duration (e.g. at least 3 months). The lithographic tool will feed this data into the optimization algorithm.

The embodiments described above may include a lithographic apparatus, the lithographic apparatus comprising a sensor, the device of the disclosure being arranged at or near the sensor.

The embodiments described above may include a lithographic apparatus, the lithographic apparatus comprising at least one mirror for reflecting EUV radiation a sensor, the device of the disclosure being arranged on or near the mirror.

The embodiments described above may include a lithographic apparatus, the lithographic apparatus comprising a reticle and/or fiducial, the device according to the disclosure being arranged at or near the reticle and/or fiducial.

In an embodiment, the radiation is extreme ultraviolet (EUV) radiation.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the clauses set out below.
1. A method of determining a set of machine constants used for a model of interest related to at least one parameter of interest and to a process; the method comprising:
   obtaining process data relating to said process;
   obtaining a set of optimization ranges, comprising a respective optimization range calibrated for each machine constant of said set of machine constants; and
   optimizing said set of machine constants within said set of optimization ranges based on said process data.
2. A method of clause 1, wherein said optimization ranges have been calibrated for each machine constant according to a sensitivity of the machine constant to said at least one parameter of interest and/or a performance indicator related to performance of the model of interest.
3. A method of clause 2, wherein the performance indicator comprises a prediction accuracy metric relating to a prediction accuracy of the model of interest.
4. A method of any of the preceding clauses, wherein said optimizing step comprises:
   a) obtaining a first candidate set of machine constants within said set of optimization ranges;
   b) determining, within said set of optimization ranges, one or more variations of said first candidate set of machine constants in a first optimization layer, to obtain one or more varied candidate sets of machine constants;
   c) assessing each of these one or more varied candidate sets of machine constants to determine if any improve performance of the model of interest;
   d) if at least one of the varied candidate sets is assessed to improve performance at step c), determining, within said set of optimization ranges, one or more further variations of said one or more varied candidate sets of machine constants in a next optimization layer;
   e) repeating steps c) and d) until convergence on said set of machine constants.
5. A method of clause 4, wherein, in each repetition at step e): if none of the varied candidate sets is assessed to improve performance at step c), propagating the best performing variation from the previous optimization layer to the next optimization layer.
6. A method of clause 4 or 5, wherein said assessing at step c) comprises assessing a prediction metric describing an accuracy of a prediction predicted by said model of interest.
7. A method of any of the preceding clauses, comprising determining said set of optimization ranges by:
   obtaining training data related to the process;
   obtaining said model of interest;
   determining a sensitivity of each machine constant of the set of machine constants to said at least one parameter of interest and/or a performance indicator relating to a performance of the model of interest; and
   attributing a respective optimization range to each machine constant according to said respective sensitivity determined for each machine constant.
8. A method of clause 7, comprising:
   classifying said process data into a plurality of data classes; and
   determining said set of optimization ranges separately for each of said data classes to obtain a plurality of sets of optimization ranges, each set of optimization ranges corresponding to a different data class of a plurality of data classes.
9. A method of any of the preceding clauses, further comprising:
   classifying said process data into one of a plurality of data classes by applying a data classifier to said process data;
   selecting said set of machine constants as the set of machine constants corresponding to the data class into which the process data is classified.
10. A method of clause 9, further comprising:
   obtaining training data, said training data comprising labeled training data; and
   performing a supervised training of the data classifier using the training data.
11. A method of any of the clauses 8 to 10, wherein said data classes relate to one or more drift characteristics of a parameter of interest modeled by said model of interest.
12. A method of any of the clauses 8 to 11, wherein said data classes relate to one or both of: a drift rate of said parameter of interest and a maintenance action frequency of a maintenance action forming part of said process.
13. A method of clause 7 or 10, comprising obtaining a data generator operable to simulate one or more aspects of said process and/or at least one machine used in said process; and
   using said data generator to generate said training data.
14. A method of clause 13, wherein said data generator is operable to simulate drift behavior of the parameter of interest and/or a related parameter.
15. A method of any of the preceding clauses, wherein said model of interest comprises a prediction model for predicting a parameter of interest relating to the process.
16. A method of clause 15, wherein said prediction model is operable to predict a calibration metric for calibrating a sensor reading for a sensor relating to the process.
17. A method of clause 16, wherein said prediction model is further operable to predict a sensor value for the sensor using said calibration metric.
18. A method of clause 16 or 17, wherein said sensor is a dose sensor of a lithography apparatus.
19. A method of any of the preceding clauses, comprising using the optimized set of machine constants and said model of interest to predict the parameter of interest.
20. A method of any of the preceding clauses, wherein said process is a lithographic process and/or a metrology process.
21. A computer program comprising program instructions operable to perform the method of any preceding clauses, when run on a suitable apparatus.
22. A non-transient computer program carrier comprising the computer program of clause 21.
23. A processing arrangement comprising:
   a non-transient computer program carrier comprising a computer program comprising program instructions operable to perform the method of any of the clauses 1 to 20, when run on a suitable apparatus; and
   a processor operable to run the computer program comprised on said non-transient computer program carrier.
24. A lithographic apparatus comprising:
   a patterning device support for supporting a patterning device;
   a substrate support for supporting a substrate; and
   the processing arrangement of clause 23.
25. A lithographic apparatus of clause 24, further comprising a sensor, wherein said processing arrangement is operable to determine a predicted value for a calibration metric for said sensor.
26. A metrology apparatus comprising:
   a support for a substrate;
   an optical system for illuminating said structure with measurement radiation;
   a detector for detecting the measurement radiation scattered by the structure; and
   the processing arrangement of clause 23.
27. A metrology apparatus of clause 26, further comprising a sensor, wherein said processing arrangement is operable to determine a predicted value for a calibration metric for said sensor.

## Claims

1. A method of determining a set of machine constants used for a model of interest related to at least one parameter of interest and to a process; the method comprising:
obtaining process data relating to said process;
obtaining a set of optimization ranges, comprising a respective optimization range calibrated for each machine constant of said set of machine constants; and
optimizing said set of machine constants within said set of optimization ranges based on said process data.

2. A method as claimed in claim 1, wherein said optimization ranges have been calibrated for each machine constant according to a sensitivity of the machine constant to said at least one parameter of interest and/or a performance indicator related to performance of the model of interest.

3. A method as claimed in claim 2, wherein the performance indicator comprises a prediction accuracy metric relating to a prediction accuracy of the model of interest.

4. A method as claimed in any preceding claim, wherein said optimizing step comprises:
a) obtaining a first candidate set of machine constants within said set of optimization ranges;
b) determining, within said set of optimization ranges, one or more variations of said first candidate set of machine constants in a first optimization layer, to obtain one or more varied candidate sets of machine constants;
c) assessing each of these one or more varied candidate sets of machine constants to determine if any improve performance of the model of interest;
d) if at least one of the varied candidate sets is assessed to improve performance at step c), determining, within said set of optimization ranges, one or more further variations of said one or more varied candidate sets of machine constants in a next optimization layer;
e) if none of the varied candidate sets is assessed to improve performance at step c), propagating the best performing variation from the previous optimization layer to the next optimization layer
f) repeating steps c) d) and e) until convergence on said set of machine constants.

5. A method as claimed in any preceding claim, comprising determining said set of optimization ranges by:
obtaining training data related to the process;
obtaining said model of interest;
determining a sensitivity of each machine constant of the set of machine constants to said at least one parameter of interest and/or a performance indicator relating to a performance of the model of interest; and
attributing a respective optimization range to each machine constant according to said respective sensitivity determined for each machine constant.

6. A method as claimed in claim 5, comprising:
classifying said process data into a plurality of data classes; and
determining said set of optimization ranges separately for each of said data classes to obtain a plurality of sets of optimization ranges, each set of optimization ranges corresponding to a different data class of a plurality of data classes.

7. A method as claimed in any preceding claim, further comprising:
classifying said process data into one of a plurality of data classes by applying a data classifier to said process data;
selecting said set of machine constants as the set of machine constants corresponding to the data class into which the process data is classified.

8. A method as claimed in claim 7, further comprising:
obtaining training data, said training data comprising labeled training data; and
performing a supervised training of the data classifier using the training data.

9. A method as claimed in claim any of claims 6 to 8, wherein said data classes relate to one or more drift characteristics of a parameter of interest modeled by said model of interest.

10. A method as claimed in claim 5 or 8, comprising obtaining a data generator operable to simulate one or more aspects of said process and/or at least one machine used in said process; and
using said data generator to generate said training data.

11. A method as claimed in any preceding claim, wherein said model of interest comprises a prediction model for predicting a parameter of interest relating to the process and/or a calibration metric for calibrating a sensor reading for a sensor relating to the process; and
wherein said assessing at step c) comprises assessing a prediction metric describing an accuracy of a prediction predicted by said prediction model.

12. A method as claimed in any preceding claim, comprising using the optimized set of machine constants and said model of interest to predict the parameter of interest.

13. A computer program comprising program instructions operable to perform the method of any preceding claim, when run on a suitable apparatus.

14. A lithographic apparatus comprising:
a patterning device support for supporting a patterning device;
a substrate support for supporting a substrate; and
a processing arrangement operable to run the computer program of claim 13;
a sensor, wherein said processing arrangement is operable to determine a predicted value for a calibration metric for said sensor.

15. A metrology apparatus comprising:
a support for a substrate;
an optical system for illuminating said structure with measurement radiation;
a processing arrangement operable to run the computer program of claim 13;
a sensor, wherein said processing arrangement is operable to determine a predicted value for a calibration metric for said sensor.
